(19) Europäisches Patentamt

European Patent Office

Office européen des brevets

(11) **EP 4 528 376 A1**

(12) **EUROPEAN PATENT APPLICATION**

(43) Date of publication:
26.03.2025 Bulletin 2025/13

(21) Application number: 23198239.8

(22) Date of filing: **19.09.2023**

(51) International Patent Classification (IPC):
*G03F 7/00* (2006.01)    *G02B 7/18* (2021.01)

(52) Cooperative Patent Classification (CPC):
**G03F 7/70883; G02B 5/0891; G02B 7/18;
G03F 7/702; G03F 7/70825; G03F 7/70941;
G03F 7/70983**

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: **ASML Netherlands B.V.**
5500 AH Veldhoven (NL)

(72) Inventors:
• **NIKIPELOV, Andrey**
5500AH Veldhoven (NL)
• **VAN DE KERKHOF, Marcus, Adrianus**
5500 AH Veldhoven (NL)

• **CLOIN, Christian, Gerardus, Norbertus,
Hendricus,
Marie**
5500AH Veldhoven (NL)
• **VAN MIL, Joost, Johannes, Lambertus**
5500AH Veldhoven (NL)
• **VAN KAMPEN, Maarten**
5500 AH Veldhoven (NL)
• **CATS, Selwyn, Yannick, Frithjof**
5500AH Veldhoven (NL)

(74) Representative: **ASML Netherlands B.V.
Corporate Intellectual Property
P.O. Box 324
5500 AH Veldhoven (NL)**

Remarks:
Claims 16 to 49 are deemed to be abandoned due to
non-payment of the claims fee (Rule 45(3) EPC).

(54) **OPTICAL ELEMENT FOR USE IN EUV LITHOGRAPHY**

(57) An optical element (150) for an EUV lithographic apparatus, the optical element comprising: an optical surface (151) configured to receive radiation; a support member (152) that is electrically conductive; and a spacer (155) that is electrically insulating and configured to electrically isolate the optical surface, wherein a capacitance between surfaces separated by the spacer is less than 1 pF.

Fig. 4A

**Description**

FIELD

The present invention relates to an optical element for an EUV lithographic apparatus, an EUV lithographic apparatus comprising the optical element, a method of manufacturing a device including use of the optical element, and a method of exposing an optical element in an EUV lithographic apparatus.

BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., comprising part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned.

Lithography is widely recognized as one of the key steps in the manufacture of ICs and other devices and/or structures. However, as the dimensions of features made using lithography become smaller, lithography is becoming a more critical factor for enabling miniature IC or other devices and/or structures to be manufactured.

A theoretical estimate of the limits of pattern printing can be given by the Rayleigh criterion for resolution as shown in equation (1):

$$CD = k_1 * \frac{\lambda}{NA} \tag{1}$$

where $\lambda$ is the wavelength of the radiation used, NA is the numerical aperture of the projection system used to print the pattern, k1 is a process-dependent adjustment factor, also called the Rayleigh constant, and CD is the feature size (or critical dimension) of the printed feature. It follows from Equation (1) that reduction of the minimum printable size of features can be obtained in three ways: by shortening the exposure wavelength $\lambda$, by increasing the numerical aperture NA or by decreasing the value of k1.

In order to shorten the exposure wavelength and, thus, reduce the minimum printable size, it has been proposed to use an extreme ultraviolet (EUV) radiation source. EUV radiation is electromagnetic radiation having a wavelength within the range of 10-20 nm, for example within the range of 13-14 nm. It has further been proposed that EUV radiation with a wavelength of less than 10 nm could be used, for example within the range of 5-10 nm such as 6.7 nm or 6.8 nm. Such radiation is termed extreme ultraviolet radiation or soft x-ray radiation. Possible sources include, for example, laser-produced plasma sources, discharge plasma sources, or sources based on synchrotron radiation provided by an electron storage ring, or a free electron laser

A lithographic apparatus may comprise a plurality of optical elements. Optical elements comprise optical surfaces which are exposed to EUV radiation during the operation of the lithographic apparatus.

The environment within the lithographic apparatus may comprise Hydrogen at a low pressure. Pulses of EUV radiation generated by the lithographic apparatus may excite hydrogen molecules within the environment surrounding the optical elements, such that plasma is formed. Energetic ions from the plasma may impact optical surfaces, causing damage thereto. This can decrease the lifetime of the optical components within the lithographic apparatus.

SUMMARY OF THE INVENTION

The present invention is directed to extending the lifetime of optical elements within a lithographic apparatus. This is achieved by providing an optical element which is less susceptible to damage from energetic ions present in the environment surrounding the optical element.

Typically, the optical surface an optical element is grounded through an electrical connection with a frame of the lithographic apparatus. The inventors of the present invention have discovered that optical surfaces may be made to be less susceptible to damage from ions in the plasma if they are electrically isolated.

According to the present invention, there is provided an optical element for an EUV lithographic apparatus, the optical element comprising: an optical surface configured to receive radiation; a support member that is electrically conductive; and a spacer that is electrically insulating and configured to electrically isolate the optical surface, wherein a capacitance between surfaces separated by the spacer is less than 1 $\mu$F.

According to the present invention, there is provided an EUV lithographic apparatus comprising: an optical element; a grounded frame; and a radiation source configured to generate the pulse of radiation.

Also according to the present invention, there is provided a method of exposing an optical element in an EUV lithographic apparatus, the method comprising: providing the optical element on a grounded frame of the EUV lithographic apparatus, wherein an optical surface of the optical element is configured to receive EUV radiation, and the optical surface is electrically isolated by an electrically insulating spacer; generating a pulse of radiation with a radiation source; exposing the optical surface with the pulse of radiation; and accumulating positive charge on the optical surface whilst the optical surface is exposed to the pulse of radiation.

As a result of the photoelectric effect, the EUV radiation incident on an optical surface may cause electrons to be ejected from therefrom. By providing an electrically insulating spacer that is configured to electrically isolate the optical surface, the ejection of electrons from the optical surfaces may bring the optical surface to a positive potential. Consequently, positive ions within the EUV plasma may be repelled from the optical surface. Consequently, fewer positive ions will collide with the optical surface, and the positive ions that do collide with the optical surface will have a lower energy. This means that the damage caused to the optical surface by the ions is decreased.

BRIEF DESCRIPTION OF THE DRAWINGS

Embodiments of the invention will now be described, by way of example only, with reference to the accompanying schematic drawings, in which corresponding reference symbols indicate corresponding parts.

Figure 1 schematically depicts a lithographic apparatus.
Figure 2 schematically depicts a more detailed view of the lithographic apparatus.
Figure 3 depicts an optical element of a lithographic apparatus, which may not be in accordance with the present invention.
Figures 4A and 4B depict an optical element of a lithographic apparatus in accordance with the embodiments of present invention.
Figure 5 depicts an example of ion energy distribution function (EDF) for Hydrogen ions incident on a grounded surface and a floating surface, that are illuminated by EUV in low pressure Hydrogen environment
Figure 6 depicts a segmented mirror, which may not be in accordance with the present invention.
Figures 7A and 7B depict facets of a multi-facet mirror in accordance with embodiments of the present invention, and Figure 7C depicts a multi-facet mirror in accordance with embodiments of the present invention.
Figure 8 depicts a portion of a lithographic apparatus comprising a membrane arrangement that is arranged to cover an opening between a projection system PS and a wafer region WR.
Figure 9 depicts the membrane arrangement in greater detail.
Figures 10A and 10B depict a membrane arrangement in accordance with embodiments of the present invention.
Figure 10C and 10D depict a portion of a clamping system configured to clamp the membrane arrangement, in accordance with embodiments of the present invention.
Figure 11 depicts an IR mirror in an EUV source, which may not be in accordance with the present invention.
Figure 12 depicts the IR mirror in an EUV source, in accordance with the embodiments of present invention.

The features shown in the Figures are not necessarily to scale, and the size and/or arrangement depicted is not limiting. It will be understood that the Figures include optional features which may not be essential to the invention. Furthermore, not all of the features of the apparatus are depicted in each of the figures, and the Figures may only show some of the components relevant for describing a particular feature.

DETAILED DESCRIPTION

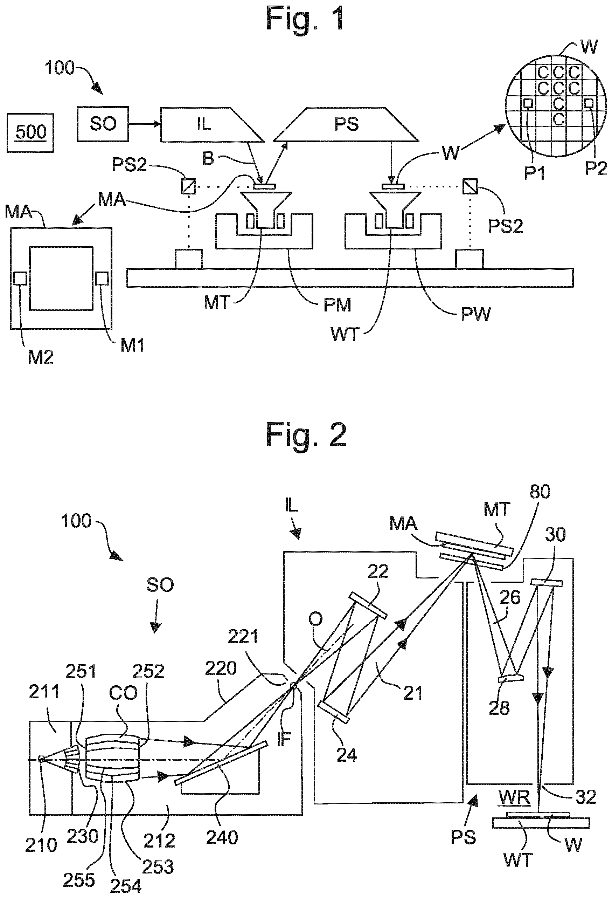

Figure 1 schematically depicts a lithographic apparatus 100 including a radiation source SO according to one embodiment of the invention. The apparatus 100 comprises:

- an illumination system (or illuminator) IL configured to condition a radiation beam B (e.g., EUV radiation).
- a support structure (e.g., a mask table) MT constructed to support a patterning device (e.g., a mask or a reticle) MA and connected to a first positioner PM configured to accurately position the patterning device;
- a substrate table (e.g., a wafer table) WT constructed to hold a substrate (e.g., a resist-coated wafer) W and connected to a second positioner PW configured to accurately position the substrate; and
- a projection system (e.g., a reflective projection system) PS configured to project a pattern imparted to the radiation beam B by patterning device MA onto a target portion C (e.g., comprising one or more dies) of the substrate W.

The illumination system IL may include various types of optical components, such as refractive, reflective, magnetic, electromagnetic, electrostatic or other types of optical components, or any combination thereof, for directing, shaping, or controlling radiation.

The support structure MT holds the patterning device MA in a manner that depends on the orientation of the patterning device, the design of the lithographic apparatus, and other conditions, such as for example whether or not the patterning device is held in a vacuum environment. The support structure MT can use mechanical, vacuum, electrostatic or other clamping techniques to hold the patterning device MA. The support structure MT may be a frame or a table, for example, which may be fixed or movable as required. The support structure MT may ensure that the patterning device MA is at a desired position, for example with respect to the projection system PS.

The term "patterning device" should be broadly interpreted as referring to any device that can be used to impart a radiation beam B with a pattern in its cross-section such as to create a pattern in a target portion C of the substrate W. The pattern imparted to the radiation beam B may correspond to a particular functional layer in a device being created in the target portion C, such as an integrated circuit.

Examples of patterning devices include masks, programmable mirror arrays, and programmable liquid-crystal display (LCD) panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

The projection system PS, like the illumination system IL, may include various types of optical components, such as refractive, reflective, magnetic, electromagnetic, electrostatic or other types of optical components, or any combination thereof, as appropriate for the exposure radiation being used, or for other factors such as the use of a vacuum. It may be desired to use a vacuum for EUV radiation since other gases may absorb too much radiation. A vacuum environment may therefore be provided to the whole beam path with the aid of a vacuum wall and vacuum pumps.

As here depicted, the lithographic apparatus 100 is of a reflective type (e.g., employing a reflective mask).

The lithographic apparatus 100 may be of a type having two (dual stage) or more substrate tables WT (and/or two or more support structures MT). In such a "multiple stage" lithographic apparatus the additional substrate tables WT (and/or the additional support structures MT) may be used in parallel, or preparatory steps may be carried out on one or more substrate tables WT (and/or one or more support structures MT) while one or more other substrate tables WT (and/or one or more other support structures MT) are being used for exposure.

Referring to Figure 1, the illumination system IL receives an extreme ultraviolet radiation beam from the radiation source SO. The radiation source SO may be a laser produced plasma (LPP) source, a discharge produced plasma (DPP) source, a free electron laser (FEL) or any other radiation source that is capable of generating EUV radiation. Methods to produce EUV light include, but are not necessarily limited to, converting a material into a plasma state that has at least one element, e.g., xenon, lithium or tin, with one or more emission lines in the EUV range. In laser produced plasma ("LPP"), the required plasma can be produced by irradiating a fuel, such as a droplet, stream or cluster of material having the required line-emitting element, with a laser beam. The laser may be an infrared (IR) laser.

An IR mirror (not shown) may be provided in the radiation source SO. The IR mirror may be configured and arranged to direct and focus the IR laser onto a target (i.e. the fuel). An IR mirror may be configured and arranged to direct and focus a laser pre-pulse. Additionally or alternatively, the same or different IR mirror may be configured and arranged to direct and focus a laser main pulse. The laser pre-pulse may irradiate a droplet of fuel before the laser main pulse is activated. The laser pre-pulse may cause the shape of the droplet of fuel to be distorted such that it transitions from a droplet to a thin plate, wherein the thin plate has a wider diameter than the droplet in a plane that is perpendicular to the direction in which the laser pre-pule and the laser main pulse propagate. After the laser pre-pulse, the laser main pulse may irradiate the fuel. Because the fuel is in the form of a thin plate rather than a droplet, a greater proportion of the laser main pulse may be absorbed by the fuel. Thus, the generation of the EUV radiation becomes more efficient.

The radiation source SO may be filled by gas at a pressure that is less than atmospheric pressure. This may that mitigate or delay contamination of the source optics by vapor and ions of the fuel. This gas may be partially ionized in operation, for example, by the laser or by discharge-produced plasma. In such a case IR optical elements within the source may be exposed simultaneously to EUV radiation and to plasma.

The radiation source SO may be part of an EUV radiation system including a laser, not shown in Figure 1, for providing the laser beam exciting the fuel. The resulting plasma emits output radiation, e.g., EUV radiation, which is collected using a radiation collector, disposed in the radiation source SO.

The laser and the radiation source SO may be separate entities, for example when a $CO_2$ laser is used to provide the laser beam for fuel excitation. In such cases, the IR laser is not considered to form part of the lithographic apparatus 100 and the radiation beam B is passed from the laser to the radiation source SO with the aid of a beam delivery system comprising, for example, suitable directing mirrors and/or a beam expander. In other cases the source may be an integral part of the radiation source SO, for example when the source is a discharge produced plasma EUV generator, often termed as a DPP source.

The illumination system IL may comprise an adjuster for adjusting the angular intensity distribution of the radiation beam. Generally, at least the outer and/or inner radial extent (commonly referred to as σ-outer and σ-inner, respectively) of the intensity distribution in a pupil plane of the illumination system IL can be adjusted. In addition, the illumination system IL may comprise various other components, such as facetted field and pupil mirror devices. The illumination system IL may be used to condition the radiation beam B, to have a desired uniformity and intensity distribution in its cross-section.

The radiation beam B is incident on the patterning device (e.g., mask) MA, which is held on the support structure (e.g., mask table) MT, and is patterned by the patterning device MA. After being reflected from the patterning device (e.g., mask) MA, the radiation beam B passes through the projection system PS, which focuses the radiation beam B onto a target portion C of the substrate W. With the aid of the second positioner PW and position sensor PS2 (e.g., an interferometric device, linear encoder or capacitive sensor), the substrate table WT can be moved accurately, e.g., so as to position different target portions C in the path of the radiation beam B. Similarly, the first positioner PM and another position sensor PS 1 can be used to accurately position the patterning device (e.g., mask) MA with respect to the path of the radiation beam B. The patterning device (e.g., mask) MA and the substrate W may be aligned using mask alignment marks M1, M2 and substrate alignment marks P1, P2.

A controller 500 controls the overall operations of the lithographic apparatus 100 and in particular performs an operation process described further below. Controller 500 can be embodied as a suitably-programmed general purpose computer comprising a central processing unit, volatile and non-volatile storage means, one or more input and output devices such as a keyboard and screen, one or more network connections and one or more interfaces to the various parts of the lithographic apparatus 100. It will be appreciated that a one-to-one relationship between controlling computer and lithographic apparatus 100 is not necessary. In an embodiment of the invention one computer can control multiple lithographic apparatuses 100. In an embodiment of the invention, multiple networked computers can be used to control one lithographic apparatus 100. The controller 500 may also be configured to control one or more associated process devices and substrate handling devices in a lithocell or cluster of which the lithographic apparatus 100 forms a part. The controller 500 can also be configured to be subordinate to a supervisory control system of a lithocell or cluster and/or an overall control system of a fab.

Figure 2 shows the lithographic apparatus 100 in more detail, including the radiation source SO, the illumination system IL, and the projection system PS. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a field facet mirror device 22 and a pupil facet mirror device 24. The field facet mirror device 22 and pupil facet mirror device 24 together provide the EUV radiation beam B with a desired cross-sectional shape and a desired intensity distribution. The illumination system IL may include other mirrors or devices in addition to, or instead of, the field facet mirror device 22 and pupil facet mirror device 24.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 28, 30 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 28,30 in Figure 1, the projection system PS may include a different number of mirrors (e.g. six or eight mirrors).

A region in which the substrate table (e.g., the wafer table) WT is disposed may be referred to as the substrate region WR. The substrate region WR may be adjacent to the projection system PS. The patterned EUV radiation beam B' may propagate from the projection system PS to the substrate region WR through an opening 32. The opening may be covered by a membrane (not shown). The membrane may be referred to as a dynamic gas lock membrane (i.e. a DGL membrane). The DGL membrane may form a physical barrier between the substrate region WR and the projection system PS. This may prevent contaminants that are outgassed from a layer of photoresist on the substrate W from travelling into the projection system PS. The DGL membrane may allow the passage therethrough of EUV radiation. The DGL membrane may limit the passage therethrough of IR and DUV radiation. If IR and DUV are allowed to propagate to the substrate W, the pattern imparted to the substrate W may be distorted.

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, in the projection system PS, and/or in the wafer region WR.

The radiation source SO may be a laser produced plasma (LPP) source, a discharge produced plasma (DPP) source, a free electron laser (FEL) or any other radiation source that is capable of generating EUV radiation.

The EUV radiation within the lithographic apparatus may excite the Hydrogen present therein to form a hydrogen plasma. Hydrogen ions in the environment within the lithographic apparatus may include $H^+$ ions, $H_2^+$ ions and $H_3^+$ ions. The environment within the lithographic apparatus, and particularly within the illumination system IL and the projection system PS, may include $H_3O^+$ ions and $N_2H^+$ ions. The environment within the lithographic apparatus, and particularly within the substrate region WR may include $N_2H^+$ ions, $H_3O^+$ ions and $H_2F^+$ ions. These ions may be formed when impurities in the environment within the lithographic apparatus, such as HzO, $N_2$, HF, capture $H^+$ ions. Other ions that may be present in the lithographic apparatus may include $CH_3^+$ ions and $C_xH_y^+$ ions.

Hydrogen ions, with energy exceeding approximately 10 eV, may cause damage via implantation, accumulation of Hydrogen bubbles and blistering/delamination of thin films. Heavier ions, such as $H_3O+$, $N_2H+$, $H_2F+$, with energy exceeding approximately 10 eV, may cause EUV transmission or reflection loss as they implant and accumulate within thin layers and absorb EUV more readily than the original materials of the optical elements. Such damage can affect EUV reflecting components (EUV mirrors), EUV transmitting components (DGL membrane), and IR reflecting components (mirrors guiding pre-pulse or main-pulse laser beams in EUV LPP sources).

Through mechanisms such as those described above, positive ions within the lithographic apparatus can cause damage to surfaces within the lithographic apparatus. This damage may be particularly significant to optical surfaces. The damage can decrease the lifetime of optical components (i.e. components on which the optical surfaces are formed) within the lithographic apparatus. The present invention seeks to reduce the damage caused by positive ions to an optical surface within the lithographic apparatus by reducing the number of positive ions incident on the optical surface and/or reducing the energy of the positive ions that impact the optical surface.

An optical surface may be a surface which is exposed to EUV radiation when the lithographic apparatus is in use. An optical element may be a component comprising the optical surface. The optical surface may be a surface which is designed in consideration of its interaction with EUV radiation. The optical surface may be a surface with optical power. That is, the optical surface may be a surface which is configured to manipulate a beam of EUV radiation. For example, the optical surface may be a surface which is configured to reflect a beam of EUV radiation. That is, the optical surface may be a reflective surface. The reflective surface may be a surface which is configured to reflect a beam of radiation in the illumination system IL. For example, the reflective surface may be a surface of the field facet mirror 22 or a surface of the pupil facet mirror 24. Alternatively, an optical surface may be a surface of the collector mirror CO within the EUV source.

Alternatively, an optical surface may be a surface which is configured not to substantially interact with EUV radiation. For example, an optical surface may be a surface which is configured to allow the transmission of EUV radiation therethrough. For example, the optical surface may be a surface of a protective membrane, such as a surface of the dynamic gas lock (DGL) membrane.

Alternatively, the optical surface may be a surface which does not need to be exposed to EUV radiation to perform its functionality, but may nevertheless be exposed to EUV radiation as a matter of course due to its positioning within the lithographic apparatus. For example, an optical surface may be a surface of an infrared (IR) reflective element, such as an IR mirror in the EUV source.

Alternatively, the optical surface may be an alignment mark.

When an optical surface is exposed to a beam of EUV radiation, electrons may be released from the optical surface as a result of the photoelectric effect. If the optical surface is grounded, the ejection of electrons from the optical surface may not cause the optical surface to become charged, or bring the optical surface to a non-zero potential relative to ground, because the electrons ejected from the optical surface will be replaced. Ground may be any of a number of reference potentials. For example, the potential of the frame of the EUV lithographic apparatus is typically used as the ground potential.

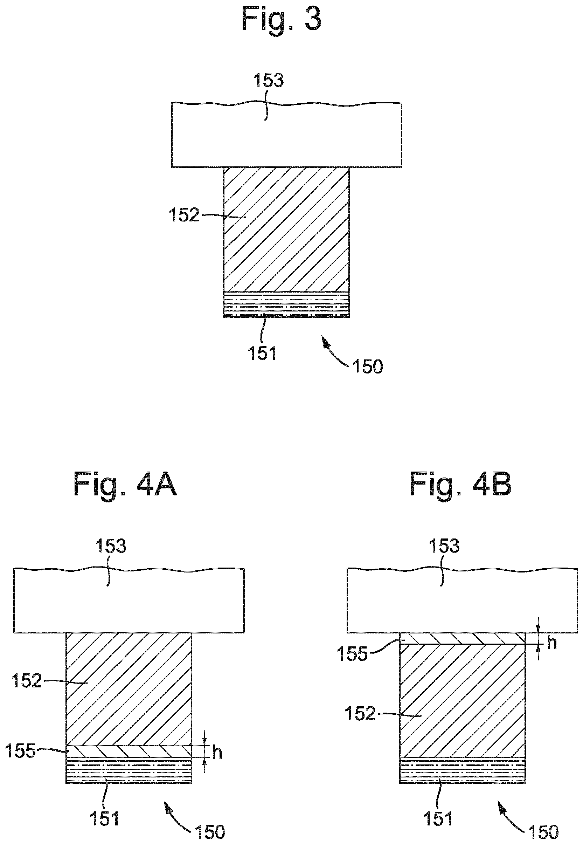

Typically, optical surfaces in a lithographic apparatus may be grounded. Grounding may occur as a result of an electrical connection, i.e. electrically conductive path, between the optical surface and the frame of the lithographic apparatus. A grounded optical element 150 is depicted in Figure 3. The optical element 150 may comprise an optical surface 151 and a support member 152. The optical surface 151 and the support member 152 may be physically connected. For instance, the optical surface 151 may be formed on the support member 152. The optical surface 151 may be electrically connected to the support member 152 via a very low resistance or inductance. The support member 152 may be formed from a thermally conductive material. This may be so that the support member 152 can conduct heat away from the optical surface 151, thus maintaining the temperature of the optical surface 151 within acceptable limits. The thermally conductive material from which the support member 152 is formed may also be electrically conductive. For example, the support member 152 may be formed of a metal, e.g. copper.

The optical element 150 may be mounted, directly or indirectly, on the frame 153 of the lithographic apparatus. The frame 153 may be grounded. For example, the support member 152 may be physically and electrically connected to the frame 153 of the lithographic apparatus with a very small resistance and/or inductance therebetween. Consequently, a resistance and/or inductance between the optical surface 151 and the frame 153 of the lithographic apparatus may be very small. In some embodiments, other components may be interposed between the support member 152 and the frame 153 of the lithographic apparatus, but the resistance and/or inductance between the optical surface 151 and the frame 153 of the lithographic apparatus may remain at a very small value.

In the context of the present description, the term "grounded" may mean that an electrical connection is present between a component and the earth. However, this is not essential. For example, a component may be referred to as grounded if it is connected to a large conductor. For instance, a component may be considered to be grounded if it is electrically connected to the frame 153 of the lithographic apparatus, even if the frame 153 itself is not electrically connected to the earth.

Further, the term "grounded" is used in the context of the timescales on which the lithographic apparatus operates. Within an EUV lithographic apparatus, EUV radiation may be generated in pulses. Each pulse may last for approximately 100 ns. The hydrogen plasma may exist within the lithographic apparatus during each pulse of EUV radiation, and for a period of time after each pulse of EUV radiation has terminated. The period of time may be approximately 10... 100 $\mu$s. A component or surface may be considered to be grounded if it can be significantly discharged during a pulse of radiation. That is, a component or surface may be considered to be grounded if it can be significantly discharged in less than approximately 100 ns.

Embodiments of the present invention are directed to providing an optical surface 151 which is able to take on a positive potential during operation of a lithographic apparatus, at least during EUV pulse and shortly thereafter. According to embodiments of the present invention, there is provided an optical element 150 in which the optical surface 151 is electrically isolated. The optical surface 151 may therefore be referred to as floating, or electrically floating. If the optical surface 151 is floating, the ejection of electrons from the optical surface 151 may cause the optical surface 151 to become positively charged. This is because it may not be possible for the electrons ejected from the optical surface 151 to be quickly replaced.

The positive charge Q, induced by EUV photo-effect on the optical surface 151 may lead to a positive potential building-up on the optical surface 151. The capacitance may be between the optical surface and the frame 153 of the lithographic apparatus. The magnitude of the positive potential to which the optical surface 151 is brought may be dependent on the capacitance between the frame 153 of the lithographic apparatus and the optical surface. This relationship is shown in *Equation 2*, where V is the potential between the optical surface 151 and the frame 153 of the lithographic apparatus; Q is the charge of the optical surface 151 (relative to the frame 153 of the lithographic apparatus); and C is the capacitance between optical surface 151 and the frame 153 of the lithographic apparatus. The voltage may be limited to approximately 50 V to approximately 80V. This may be cause the absorbed EUV photon energy (92 eV) is divided between kinetic energy of escaping electron (e*V), and the work function of optical surface (which may range from approximately 5eV to approximately 15eV) and ionization of a single atom from the optical surface (approximately 10 eV to approximately 30 eV).

$$V \leq \frac{Q}{C} \qquad\qquad\qquad (2)$$

A component or surface may be floating if the component is not grounded. A component or surface may be floating if the component or surface is not connected to any conductive components which may be considered to be a ground, or which are themselves grounded. A component or surface may be considered to be floating if the component or surface is electrically isolated. The terms "floating" and "isolated" are used in the context of the timescales of an EUV pulse. That is, an optical surface 151 may be considered to be floating if, when electrons are ejected therefrom by virtue of the photoelectric effect during a pulse of EUV radiation, it can acquire and maintain a charge for the duration of the pulse of EUV radiation. That is, a component or surface may be considered to be floating if it is not significantly discharged in at least approximately 100 ns. For example the surface is considered to be floating if it discharges less than 10% in 100 ns.

An optical surface 151 may be made to be floating and/or electrically isolated by providing a spacer 155 to the optical element 150. The spacer 155 may be electrically insulating. An optical element 150 comprising a spacer 155 is depicted in Figures 4A and 4B. The spacer 155 may electrically isolate the optical surface 151. This may be achieved by interposing the spacer 155 between the optical surface 151 and the frame 153 of the lithographic apparatus. The exact location of the spacer 155 may not be particularly limited. For example, the spacer 155 may be disposed between the optical surface 151 and the support member 152 (as depicted in Figure 4A). Alternatively, the spacer 155 may be disposed between the support member 152 and the grounded frame 153 (as depicted in Figure 4B).

In addition to being isolated from the frame 153 of the lithographic apparatus, the optical surface 151 may be isolated from other components within the lithographic apparatus. For example, during the pulse of EUV radiation, the optical surface 151 may not be electrically connected to any power source or equivalent. No significant potential (relative to the grounded frame 153) may be imposed on the optical surface 151. Thus, the potential of the optical surface 151 relative to the frame 153 of the lithographic apparatus may be substantially a function of the charge accumulated on the optical surface 151 and the capacitance between the optical surface 151 and the frame 153 of the lithographic apparatus.

The electrical isolation of the optical surface 151 within the optical element 150 may be such that, during the pulse of EUV radiation and for the period of time thereafter, the potential of the optical surface 151 is greater than 1 V, preferably greater than 5 V and further preferably greater than 10 V, relative to the frame 153 of the lithographic apparatus. That is, the lithographic apparatus may be configured such that the exposure of an optical surface 151 to a pulse of EUV radiation causes the optical surface 151 to have a potential of greater than 1 V, preferably greater than 5 V and further preferably greater than 10 V during the pulse of EUV radiation.

As shown in *Equation* 2, the potential to which the optical surface 151 is brought (relative to the frame 153 of the lithographic apparatus) is inversely proportional to the capacitance between the optical surface 151 and the grounded frame 153. Thus, if the optical surface 151 accumulates a given amount of charge, a lower capacitance between the optical surface 151 and the grounded frame 153 results in the optical surface 151 being brought to a higher potential. In embodiments of the present invention, a larger potential is desirable, because it means that positive ions within the environment of the lithographic apparatus will be repelled to a greater extent. Consequently, a lower capacitance between the optical surface 151 and the frame 153 of the lithographic apparatus may be desirable. According to embodiments of the present invention, it may be preferable that the capacitance between the optical surface 151 and the grounded frame 153 is less than 1000 $\mu$F, preferably less than 100 $\mu$F, and more preferably less than 1 $\mu$F. Such a capacitance may ensure that, when the optical surface 151 is charged by the beam of EUV radiation, the potential of the optical surface 151 relative to the frame 153 of the lithographic apparatus is sufficient to effectively repel positive ions in the environment within the lithographic apparatus from the optical surface 151. A capacitance between the optical surface 151 and the grounded frame 153 of less than 1 $\mu$F may ensure that the charging of the optical surface 151 by the pulse of EUV radiation is sufficient to bring the optical surface 151 to a potential of greater than 1 V, preferably greater than 5 V and further preferably greater than 10 V. The capacitance between optical surface 151 and the frame 153 of the lithographic apparatus may preferably be less than 0.1 $\mu$F, preferably less than 0.05 $\mu$F, and preferably less than 0.01 $\mu$F. A lower capacitance may mean that if the optical surface 151 is charged by a given amount, the optical surface 151 is brought to a higher potential, and thus can more effectively repel positive ions within the lithographic apparatus. A lower capacitance may also mean that, if the optical surface 151 is not charged as anticipated (e.g. if the quantum efficiency of the photoelectric effect is less than anticipated), the optical surface 151 may still brought to the desired potential.

In practice, the majority of the capacitance between the optical surface 151 and the grounded frame 153 may be between the surfaces which are separated by the spacer 155. If other capacitors exist in between the optical surface 151 and the frame 153 of the lithographic apparatus, the overall capacitance between the optical surface 151 and the grounded frame 153 would decrease. This is because the capacitors would be in series. When capacitors are arranged in series, the overall capacitance is less than any of the capacitances of the individual capacitors. That is, if there are capacitances in the optical element 150 in addition to the capacitance between the surfaces separated by the spacer 155, the overall capacitance will be reduced.

Considering that the majority of the capacitance between the optical surface 151 and the grounded frame 153 may be between the surfaces which are separated by the spacer 155, embodiments of the present invention may be appropriately defined with reference to the surfaces which are separated by the spacer 155. Thus, the capacitance between the surfaces separated by the spacer 155 may be less than 1 $\mu$F. Preferably, the capacitance between the surfaces separated by the spacer 155 is less than 0.1 $\mu$F, preferably less than 0.05 $\mu$F, and further preferably less than 0.01 $\mu$F.

As explained above, the terms "isolated" and "floating" are used in the context of the timescale of the EUV pulses in the lithographic apparatus. Consequently, the resistance or inductance between the optical surface 151 and the frame 153 of the lithographic apparatus may be such that the optical surface 151 is isolated or floating on this timescale. For instance, a resistance between the optical surface 151 and the grounded frame 153 may be greater than 1 $\Omega$, preferably greater than 5 $\Omega$, further preferably greater than 10 $\Omega$, and further preferably greater than 100 $\Omega$. Alternatively, an inductance between the optical surface 151 and grounded frame 153 may be greater than 10 nH, preferably greater than 50 nH, further preferably greater than 100 nH and further preferably greater than 1000 nH.

The spacer 155 may be formed of a dielectric material. Preferably, the spacer may be formed from a material comprising at least one $Al_2O_3$ or $Y_2O_3$ or $ZrO_2$. Such materials may minimize hydrogen-induced outgassing of elements such as Si, C and P from the spacer.

The spacer 155 may have a dielectric breakdown strength which is greater than the potential to which the optical surface 151 is brought, relative to the frame 153 of the lithographic apparatus. For instance, the spacer 155 may have a dielectric breakdown strength of greater than 50 V, preferably greater than 90 V, and further preferably greater than 100 V.

The majority of the resistance between the optical surface 151 and the grounded frame 153, or the inductance between the optical surface 151 and the grounded frame 153 referred to above, may be provided by the spacer 155 or an auxiliary element in series with the spacer. Consequently, such a resistance 155 may be greater than 1 $\Omega$, preferably greater than 5 $\Omega$, further preferably greater than 10 $\Omega$, and further preferably greater than 100 $\Omega$. Alternatively, such an inductance 155 may be greater than 10 nH, preferably greater than 50 nH, further preferably greater than 100 nH and further preferably greater than 1000 nH.

To provide this capacitance, a thickness of the spacer 155 may be greater than one micrometer, preferably greater than 10 micrometers, and preferably greater than 100 micrometers. In the embodiments depicted in Figures 4A and 4B, the thickness h is a dimension that is substantially parallel to the optical surface. In general, the thickness h may be a dimension of the spacer 155 parallel to a direct path between components that are separated by the spacer 155 and/or h may be a dimension orthogonal to the separated surfaces by the spacer 155.

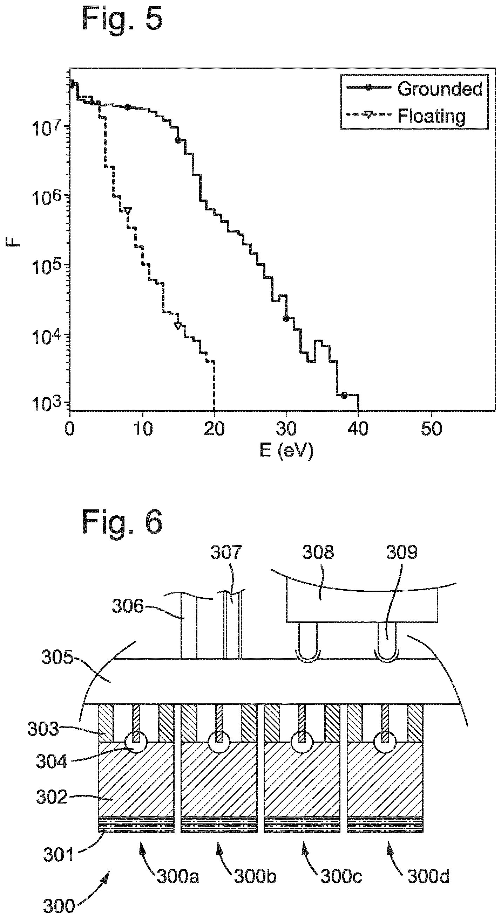

Figure 5 depicts an example of ion energy distribution function (EDF) of hydrogen ions incident on an element within a lithographic apparatus that is illuminated with an EUV radiation pulse for a grounded optical surface 151 of an optical element 150 (solid line) and a floating optical surface 151 of an optical element 150 (dashed line). The floating optical surface 151 may be electrically isolated by an insulating spacer 155. Specifically, Figure 5 depicts a plot of ion flux to the surface F on the y-axis (with units of $1/(cm^2$ pulse x EUV) and ion energy (in eV) on the x-axis. The data plotted was calculated for a case of EUV pulses illuminating optical elements at 50 kHz in an environment comprising Hydrogen with a pressure of 5 Pa.

Figure 5 shows that, for the grounded surface, a greater portion of the ions had a higher energy, for example exceeding damage threshold of approximately 10 eV. Thus, Figure 5 shows that by making a surface electrically floating on the timescale of the EUV pulse (as opposed to electrically grounded on the timescale of the EUV pulse), damage to the surface inflicted by the positive ions within the lithographic apparatus environment can be reduced.

The optical element 150 may be a reflective element. For example, the optical element 150 may be a mirror. Within the EUV lithographic apparatus, the optical element may be configured to reflect EUV radiation.

To reflect EUV radiation, the reflective element may comprise a multilayer portion. The multilayer portion may form the optical surface. The multilayer portion may be a distributed Bragg reflector. The multilayer portion may comprise alternating layers of silicon and molybdenum. However, embodiments of the present invention are not limited thereto. The multilayer portion may be deposited on a support member. The support member may be formed from a thermally conductive material. This may be so that the support member can conduct heat away from the optical surface, thus maintaining the temperature of the multilayer portion within acceptable limits. The thermally conductive material from which the support member is formed may also typically be electrically conductive. For example, the support member may be formed of a metal, e.g. copper.

Several embodiments of an optical element according to the present invention will now be described. These embodiments are intended to be exemplary, and the present invention is not limited thereto.

The reflective element may be a segmented mirror. The reflective element may be a pupil facet mirror or a field facet mirror. The pupil facet mirror and the filed facet mirror may be arranged in a lithographic apparatus as follows. After being collected by the collector CO, radiation may pass through an intermediate focus plane and then impinge on the field facet mirror. From the field facet mirror (22), the radiation may be reflected toward the pupil facet mirror (24). The radiation may be divided into a plurality of illumination channels via the facets of the field facet mirror, on the one hand, and the pupil facet mirror on the other hand, one pair of facets with a field facet or a pupil facet being precisely allocated to each illumination channel. Generally, segments of faceted mirrors rest on the tilt mechanisms, that allow to provide different settings for the angular distribution of radiation, for example EUV radiation, towards a lithographic mask.

Figure 6 depicts a typical segmented mirror 300 not in accordance with embodiments of the present invention. The segmented mirror 300 comprises a plurality facets 300a-300d. The facets 300a-300d may also be referred to as segments. Each facet 300a-300d may comprise a reflective multi-layer stack 301 and a support member 302, as described above. The support member 302 may be a metal substrate, or electrically conducting substrate. The optical surface may be formed by the multi-layer stack 301. Each facet 300a-300d may be mounted on a base 305. Each facet 300a-300d may be connected to the base 305 via a heat sink 303 and a tilt mechanism 304. The heat sink 303 may be thermally and electrically conductive. The tilt mechanism 304 may be electrically conductive. The tilt mechanism 305 of each fact 300a-300d may be individually controllable. The mirror base 305 may connected to a communication line 306, along which signals may travel to control the tilt mechanisms of the facets 300a-300d. The mirror base 305 may also be connected to a cooling line 307. The cooling line 307 may be configured to allow the flow of cooling liquid therethrough to regulate the temperature of the base 305. The base 305 may be mounted onto a grounded frame 308 via a mechanical interface 309.

In each facet 300a-300d, the multi-layer stack 301 may be formed on a first surface of the support member 302. The heat sink 303 and the tilt mechanism 304 may be connected to a second surface of the support member 302, wherein the second surface is opposite the first surface. Thus, multi-layer stack 301 may be electrically connected to the grounded frame 308 via the support member 302 and one or more of the heat sink 303 and the tilt mechanism 304. Consequently, the resistance between the multi-layer stack 301 and the grounded frame 308 may be small. That is, the optical surface may be grounded.

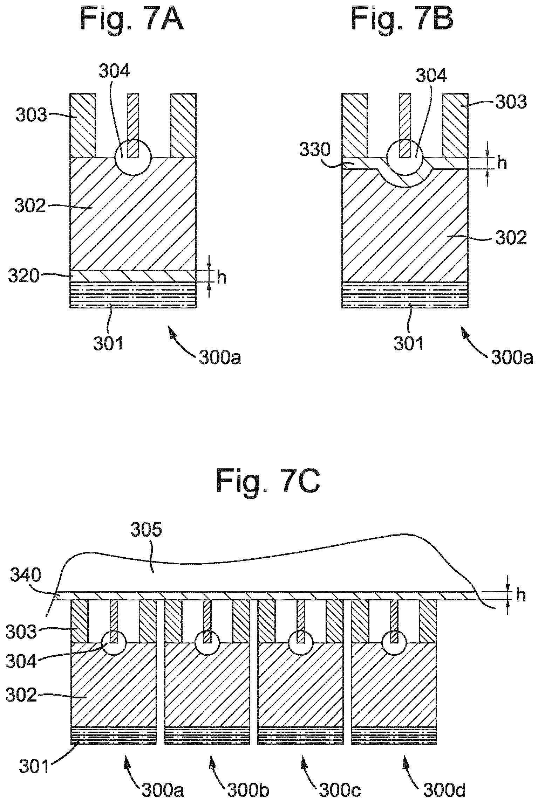

Figures 7A and 7B depict facets 300a-300d of a segmented mirror 300 in accordance with embodiments of the present invention. The segmented mirror 300 depicted in Figures 7A to 7C may be similar to the segmented mirror 300 depicted in Figure 6, except as described below. The segmented mirror 300 may comprise a spacer 320, 330, 340. The spacer may be configured to electrically isolate the multi-layer stack 301 (and therefore electrically isolate the optical surface). Specifically, the spacer 320, 330, 340 may be configured to electrically isolate the multi-layer stack 301 from the grounded frame 308. This may be such that the multi-layer stack 301 is electrically floating. The general properties of the spacer 320, 330, 340 may be as described above with reference to spacer 155.

The exact position of the spacer 320, 330, 340 may not be particularly limited, as long as it performs the functionality described above. Figure 7A depicts an embodiment in which each facet 300a-300d is provided with a spacer 320 interposed between the multi-layer stack 301 and the support member 302. That is, a first surface of the spacer 320 is in contact with the multi-layer stack 301 and a second surface of the spacer 320 is in contact with the support member 302. The spacer 320 may cover substantially all of the surfaces which it separates (i.e. opposing surfaces of the multi-layer stack 301 and the support member 302). The spacer 320 may be configured such that the multi-layer stack 301 and the support member 302 are not directly connected. The thickness h of the spacer 320 may be a dimension substantially perpendicular to the multi-layer stack 301.

Figure 7B depicts an alternative embodiment in which each facet 300a-300d is provided with a spacer 330 interposed between the support member 302 and both the heat sink 303 and the tilt mechanism 304. That is, a first surface of spacer 330 may be in contact with the support member 302, and a second surface of the spacer 330 may be in contact with one or both of the heat sink 303 and the tilt mechanism 304. The spacer 330 may cover substantially all of the surfaces which it separates (i.e. opposing surfaces of the support member 302 and one or both of the heat sink 303 and the tilt mechanism 304). The spacer 330 may be configured such that the support member 302 is not directly connected to the heat sink 303 or the tilt mechanism 304. The spacer 330 may conform to the geometry of the tilt mechanism. The thickness h of the spacer 330 may be a dimension substantially perpendicular to the multi-layer stack 301.

Figure 7C depicts a segmented mirror 300 with a spacer 340 interposed between each facet and its corresponding tilt mechanism 300a-300d and the base 305. That is, a single spacer 340 may be provided to electrically isolate the multi-layer stacks 301 of each of the facets 300a-300d. A first surface of the spacer 340 may be connected to at least one of the heat sink 303 and the tilt mechanism 304 of each of the plurality of facets 300a-300d. A second surface of the spacer 340 may be connected to the base. The spacer 340 may be configured such that the heat sinks 303 and the tilt mechanisms 304 of each facet 300a-300d are not directly connected to the base 305.

In an alternative embodiment (not shown), the spacer may be interposed between each the base 305 and the grounded frame 308. For example, the spacer may be interposed between the base 305 and the mechanical interface 309.

Another EUV reflecting element in which a spacer may be provided is an EUV collector CO (see Figure 2). The collector CO may be a normal incidence collector.

The normal incidence collector may comprise a reflective surface. A dielectric spacer may be provided to isolate the reflective surface of the normal incidence collector from the grounded frame of the source. The reflective surface may typically be grounded via components such as cooling channels and/or via gas supply lines. To ensure that the reflective surface is electrically isolated, one or more dielectric spacers may be provided within the cooling channels and/or gas supply lines.

Alternatively, the collector CO may be a grazing incidence collector. A grazing incidence collector may comprise an upstream radiation collector side 251 and a downstream radiation collector side 252. A grazing incidence collector may be a nested collector with reflectors 253, 254, 255. The reflectors 253, 254, 255 may mounted on a support element, which itself may be mounted onto the frame of the lithographic apparatus. Consequently, the reflectors 253, 254, 255 may be electrically connected to the grounded frame via the support element. That is, the reflectors 253, 254, 255 may be grounded.

In accordance with embodiments of the present invention, a spacer may be provided to the collector CO to electrically isolate the reflectors 253, 254, 255. The exact position of the spacer may not be particularly limited. A spacer may be arranged in the collector in a similar manner to how a spacer is arranged in a segmented mirror, as described above.

The optical element may be a membrane arrangement. For example, the membrane arrangement may be a dynamic gas lock (DGL) membrane arrangement.

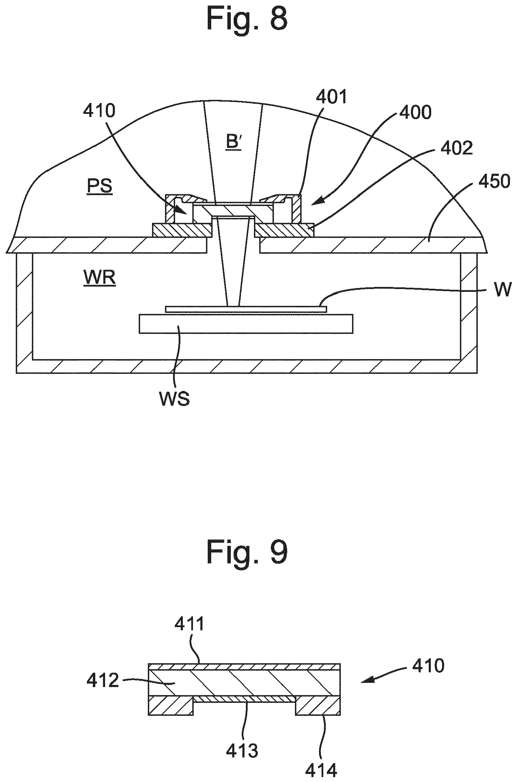

Figure 8 depicts a portion of the projection PS system and a portion of the wafer region WR. Between the projection system PS and the wafer region WR is an opening. The opening is to allow the passage of patterned EUV radiation from the projection system PS to the wafer region WR, so that the substrate W can be exposed to the patterned beam of radiation. A membrane system 400 may be provided such that a membrane arrangement 410 covers the opening. Thus, EUV radiation may pass through the membrane arrangement 410 to propagate from the projection system to the wafer region WR. The environment within the wafer region WR may comprise hydrogen at a low pressure (e.g. a few Pa). The environment within the wafer region WR may be contaminated by EUV-induced resist outgassing. The membrane arrangement 410 may prevent propagation of outgassed contaminants towards the optics in the projecting system PS. The membrane arrangement 410 may be configured to allow the passage of EUV radiation therethrough, but to filter out of band (OOB) radiation, such as DUV and IR radiation. The membrane arrangement 410 may comprise a membrane, such as a multi-layer membrane. The membrane 410 may comprise at least one electrically conducting layer, for example a metallic layer with a thickness of at least few nm.

The clamping system may comprise the membrane arrangement 410, one or more one or more clamping arms 401 and a bracket 402. The membrane arrangement 410 may be clamped into place by one or more clamping arms 401. The one or more one or more clamping arms 401 may be provided on the bracket 402. The one or more clamping arms 401 may clamp the membrane arrangement 410 such that the membrane arrangement 410 is clamped to the bracket 402. The one or more one or more clamping arms 401 may be a single clamping arm 401 which extends circumferentially around the membrane arrangement 410. Alternatively, the one or more one or more clamping arms 401 may comprise a plurality of clamping arms 401 distributed circumferentially around the membrane arrangement 410.

The bracket 402 may be connected to a grounded frame 450 of the lithographic apparatus. The one or more clamping arms 401 and the bracket 402 may be electrically conductive. The one or more clamping arms 401 and the bracket 402 may be formed of a metal or a metal alloy.

Figure 9 depicts the membrane arrangement 410. The membrane arrangement 410 may comprise an EUV transparent core layer 412. The core layer 412 may have a thickness of between 5nm and 25 nm, preferably between 10 nm and 13 nm. The core layer may be formed of a material substantially comprising polycrystalline silicon (poly-Si). On a first surface of the core layer 412, there may be a metallization layer 411. The metallization layer may be formed substantially of ruthenium or an alloy comprising molybdenum and ruthenium. On a second surface of the core layer 412, a cap layer 413 may be disposed. The second surface of the core layer 412 may be opposite to the first surface of the core layer 412. The cap layer may be formed of a material substantially comprising silicon oxide (SiOz) or zirconium oxide (ZrOz). The membrane arrangement 410 may also comprise a frame 414. The frame may have a thickness (i.e. a dimension in the vertical direction as depicted in Figure 9) of greater than approximately 100 $\mu$m and less than approximately 1,000 $\mu$m.

Typically, the metallization layer 411 is grounded. This may be because the metallization layer 411 is electrically connected to the grounded frame 450 of the lithographic apparatus. That is a resistance or inductance between the metallization layer 411 and the grounded frame 450 may be small. The metallization layer 411 may be electrically connected to the grounded frame 450 via clamping components in the clamping system 400. In the example depicted in Figure 8, the metallization layer 411 is electrically connected to the grounded frame 450 via the one or more clamping arms 401 and the bracket 402. Consequently, when the membrane arrangement 410 is exposed to EUV radiation, the membrane arrangement 410 (and specifically the metallization layer 411) cannot acquire a positive charge and cannot be brought to a positive potential.

During operation of the lithographic apparatus, heavy, positively charged molecular ions may be implanted into the cap layer 413 or 411. This may create compressive stresses in the cap layer 413 or 411. This may reduce the tension in the membrane arrangement 410, causing it to become less effective. Further, the ions may become implanted in the cap layer 413 or 411 and may increase the amount of EUV radiation absorbed by the cap layer 413 or 411. Further, hydrogen ions (e.g. $H^+$ ions) may be implanted into the cap layer 413 or 411. This may lead to outgassing of silicon or damage to the core layer 412. Further, hydrogen ions (e.g. $H^+$ ions) may be implanted into the metallization layer 411. This may lead to degradation of the metallization layer 411, through mechanisms such as de-wetting and hole formation.

By bringing the membrane arrangement 410 to a positive potential during pulses of EUV radiation, the amount of positive ions that are implanted into the metallization layer 411 and the cap layer 413 may be reduced. The membrane arrangement 410 (and, specifically, the metallization layer 411) may be brought to a positive potential by the pulses of EUV radiation if the metallization layer 411 is electrically isolated from the frame 450 of the lithographic apparatus.

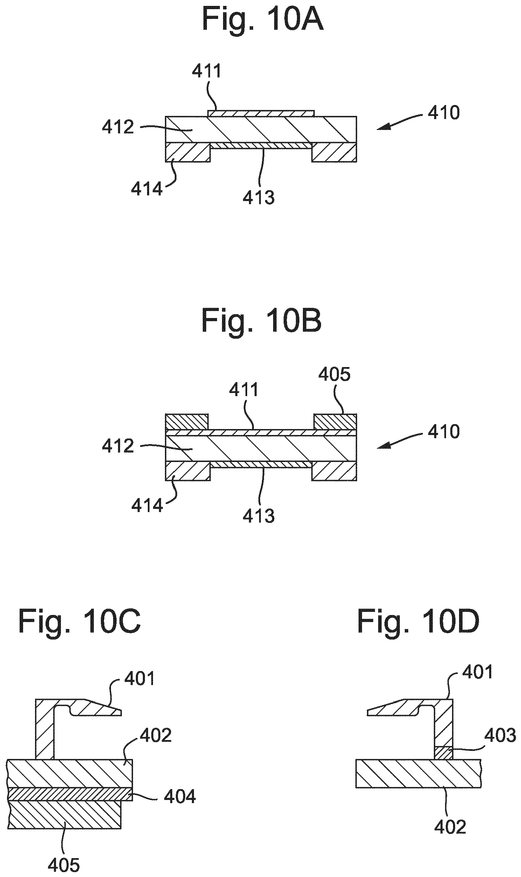

Figures 10A to 10D depict components of a clamping system 400 which may result in the metallization layer 411 being electrically isolated from the grounded frame. The electrical isolation may mean that the metallization layer 411 is floating.

Figure 10 depicts a membrane arrangement 410 with a patterned metallization layer. The metallization layer 411 may be patterned such that the metallization does not cover all of the first surface of the core layer 412. In particular, the metallization layer 411 may cover a central (radially inward) region of the EUV transparent core layer 410, but not an outer (radially outward) region of the EUV transparent core layer 412. In some embodiments, the metallization layer 411 may cover some, but not all, of the outer region. The area of the core layer 410 which is not covered by the metallization layer 411 may correspond to the areas where the one or more clamping arms 401 come into contact with the membrane arrangement 410. Consequently, when the membrane arrangement 410 is clamped by the one or more clamping arms 401, the one or more clamping arms may not come into contact with the metallization layer 411. Consequently, the metallization layer 411 may not become electrically connected to the frame 450 via the one or more clamping arms 401. The exact arrangement of the metallization layer 411 on the core layer 410 is not particularly limited, as long as the one or more clamping arms 401 can clamp the membrane arrangement 400 without contacting the metallization layer 411. Consequently, the metallization layer 411 can be electrically isolated.

In other embodiments, a spacer 403, 404, 405 may be provided to electrically isolate the metallization layer 411 from the grounded frame 450. This may be achieved by providing a spacer to the membrane arrangement 410 or the clamping system around the membrane arrangement 400. The general properties of the spacer 403, 404, 405 may be as described above with reference to spacer 155, except as described below.

Figure 10B depicts a configuration in which one or more spacers 405 are provided onto the metallization layer 411. These spacers 405 may take the form of insulative pads. The spacers 405 may be disposed in a radially outward region of the metallization layer 411. The spacers 405 may be disposed in a region corresponding to where the one or more clamping arms 401 come into contact with the membrane arrangement 410. When the membrane arrangement 410 is clamped by the one or more clamping arms 401, the one or more clamping arms 401 may come into contact with the spacers 405, rather than the metallization layer 411. That is, when the membrane arrangement 410 is clamped, the spacer 405 may be interposed between the one or more clamping arms 401 and the metallization layer 410. Therefore, the one or more clamping arms 401 may be able to clamp the membrane arrangement 410 without coming directly into contact with the metallization layer 411. This may mean that the metallization layer is electrically isolated.

The spacers 405 may be formed of any suitable dielectric material. Preferably, the spacers 405 may be formed of $SiO_2$. A thickness of the spacers 405 may be a dimension in a direction parallel to the plane of the metallization layer 411. The spacers 405 may be effective when the thickness of the spacers is greater than 100 nm. The thickness of the spacers 405 for use in a membrane system 400 may be less than the thickness of spacers used in other embodiments, such as in a segmented mirror. This is because the area of the surfaces separated by the spacers 405 used in a membrane system 400 may be smaller than the area of the surfaces separated by spacers in a segmented mirror.

Figures 10A and 10B show embodiments of membrane arrangements 410 that may be used with known clamps. Figures 10C and 10D show embodiments of clamps that may be used with known membrane arrangements. In particular, in a variant of the embodiments described above, the spacers 405 may be provided to the one or more clamping arms (not shown). Specifically, the spacers may be provided to the surfaces of the one or more clamping arms which would typically come into contact with the metallization layer 411. Consequently, when the membrane arrangement 410 is clamped, the spacers 405 may be interposed between the one or more clamping arms 401 and the metallization layer 411, as described above.

Figures 10C and 10D depict configurations in which a spacer is provided to the clamping system. Specifically, Figure 10C depicts a configuration in which a spacer 404 is provided between the bracket 402 and the grounded frame 450. Figure 10D depicts a configuration in which a spacer 404 is provided between the clamping arm 401 and the bracket 402. Consequently, the metallization layer may be electrically isolated from the grounded frame 450.

In another embodiment, one or more of the clamping components may be a non-conducting component. Consequently, the metallization layer 411 may be electrically isolated from the grounded frame 450 without the provision of a spacer. For example, at least one of the one or more clamping arms 401 and the bracket 402 may be non-conductive components. For example, at least one of the one or more clamping arms 401 and the bracket 402 may be formed from an insulative material. Alternatively, an insulative coating may be provided to at least one of the one or more clamping arms 401 and the bracket 402. The one or more non-conductive clamping components may have a dielectric breakdown strength of greater than 100 V. The one or more non-conductive clamping components may be arranged such that a resistance between the metallization layer 411 and the grounded frame 450 is greater than 1 $\Omega$, preferably greater than 5 $\Omega$, further preferably greater than 10 $\Omega$ and further preferably greater than 100 $\Omega$.

As described above, an IR (infrared) mirror may be provided in the radiation source SO. The IR mirror may be configured and arranged to direct and focus the IR laser onto a target (i.e. the fuel). To achieve this, the IR mirror must have a line-of-sight to the position where EUV radiation is generated (i.e. the point where the EUV fuel is excited). This means that the IR mirror will be exposed to EUV radiation during the operation of the lithographic apparatus.

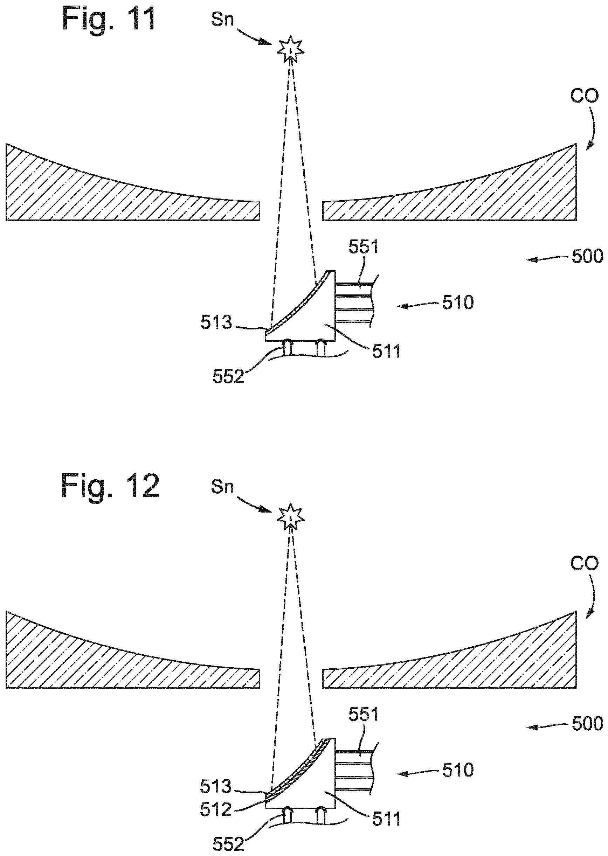

An IR mirror 510 in a source module 500 is depicted in Figure 11. The configuration depicted in Figure 11 may not be in accordance with the present invention. The IR mirror 510 may comprise a reflective surface 513 formed on a support member 511. The support member 511 may be conductive. The support member 511 may be similar to the other support members described above. The IR mirror 510 may mounted onto a frame of the lithographic apparatus by a mechanical interface 552. The IR mirror 510 may be connected to cooling lines 551, which are configured to provide cooling liquid to the IR mirror 510 so that the temperature of the IR mirror 150 can be regulated. The reflective surface 513 may be electrically connected to the frame of the lithographic apparatus via the support member 512 and at least one of the mechanical interface 552 and the cooling lines 551. This may mean that the reflective surface 513 is not brought to a positive potential when the reflective surface 513 is exposed to EUV radiation.

In accordance with embodiments of the present invention, a spacer 512 may be provided to the IR mirror 510. The spacer 512 may electrically isolate the reflective surface 513 from the frame of the lithographic apparatus. Figure 12 depicts a configuration in which the spacer 512 is interposed between the support member 511 and the reflective surface 513. For example, the spacer 512 may be formed on the support member 511 and the reflective surface 513 may be formed on the spacer 512. However, embodiments of the present invention are not limited to this configuration, and the spacer may be provided in other positions, as long as the position of the spacer is such that the reflective surface 513 is electrically isolated from the frame of the lithographic apparatus. For example, the spacer 512 may be provided between the support member 511 and the mechanical interfaces 552, and/or between the mechanical interfaces 552 and the frame of the lithographic apparatus.

The spacer 512 may have similar properties to the spacers described in relation to the other embodiments in this specification.

In accordance with embodiments of the present invention, a spacer may be provided to an alignment mark to electrically isolate a reflective surface of the alignment mark from the frame of the lithographic apparatus. Such alignment marks may be referred to as fiducials. Fiducials may be used in reticle alignment processes.

A spacer may be implemented within an alignment mark in a similar way as described with reference to the segmented mirror, the collector, the membrane arrangement and the IR mirror. For example, the spacer may be interposed between a reflective surface of the alignment mark and the frame of the lithographic apparatus. The optical element 150 depicted in Figures 4A and 4B may be an alignment mark.

During periods in which the EUV radiation is not present in the lithographic apparatus (e.g. between pulses), a positive bias voltage may be applied to the optical surface. This may be achieved by electrically connecting the optical surface to a power supply. This electrical connection may be made only when the EUV radiation is not present. That is, the electrical connection will not be made whilst the optical surface is exposed to EUV radiation. The magnitude of the voltage may be greater than 1 V, preferably greater than 2 V, and preferably greater than 5 V. The magnitude of the voltage may be less than 100 V, preferably less than 20 V, and preferably less than 15 V.

Embodiments include a number of modifications and variations to the above-described techniques.

Embodiments include the following numbered clauses:

1. An optical element for an EUV lithographic apparatus, the optical element comprising:

an optical surface configured to receive radiation;
a support member that is electrically conductive; and
a spacer that is electrically insulating and configured to electrically isolate the optical surface,
wherein a capacitance between surfaces separated by the spacer is less than 1 $\mu$F.

2. The optical element according to claim 1, wherein the capacitance between the surfaces separated by the spacer is less than 0.1 $\mu$F, preferably less than 0.05 $\mu$F, and preferably less than 0.01 $\mu$F.

3. The optical element according to claims 1 or 2, wherein the optical element is configured to be mounted on a grounded frame.

4. The optical element according to any of the preceding claims, wherein the optical surface is configured to be electrically connected to a grounded frame via an auxiliary resistance or inductance.

5. The optical element according to claims 3 or 4, wherein the optical element is configured such that, when the optical element is mounted on the grounded frame, a resistance between the optical surface and the grounded frame is greater than 1 $\Omega$, preferably greater than 5 $\Omega$, further preferably greater than 10 $\Omega$ and further preferably greater than 100 $\Omega$.

6. The optical element according to any of claims 3 to 5, wherein the optical element is configured such that, when the optical element is mounted on the grounded frame, an inductance between the optical surface and the grounded frame is greater than 10 nH, preferably greater than 50 nH, further preferably greater than 100 nH, and further preferably greater than 1000 nH.

7. The optical element according to any of claims 3 to 6, wherein the optical element is configured such that, during a pulse of EUV radiation, the optical surface becomes positively charged due to the photo-electric effect, and a potential of the optical surface becomes greater than 1 V, preferably greater than 5 V and further preferably greater than 10 V, relative to the grounded frame.

8. The optical element according to any of the preceding claims, wherein the spacer is formed from a dielectric material.

9. The optical element according to claim 8, wherein the spacer has a dielectric breakdown strength of greater than 50 V, preferably greater than 90 V, and further preferably greater than 100 V.

10. The optical element according to claim any of the preceding claims, wherein a thickness of the spacer is greater than 1 $\mu$m, preferably greater than 10 $\mu$m and preferably greater than 100 $\mu$m.

11. The optical element according to any of the preceding claims, wherein the optical element is a reflective element.

12. The optical element according to claim 11 wherein the reflective element is configured to reflect EUV radiation.

13. The optical element according to claims 11 or 12, wherein the reflective element comprises a multilayer portion which forms the optical surface.

14. The optical element according to any of claims 11 to 13, wherein the spacer is interposed between the optical surface and the support member.

15. The optical element according to claim any of claim 11 to 13, wherein the support member is coupled to a tilt mechanism configured to be electrically connected to the grounded frame, and the spacer is interposed between the support member and the tilt mechanism.

16. The optical element according to any of claims 11 to 13, wherein the support member is coupled to a tilt mechanism, and the optical element is configured such that, when the optical element is connected to the grounded

EP 4 528 376 A1

frame, the spacer is interposed between the tilt mechanism and the grounded frame.

17. The optical element according to any of claims 11 to 16, wherein the reflective element is a field facet mirror or a pupil facet mirror.

18. The optical element according to any of claims 11 to 17, wherein the optical element is formed of a plurality of segments, each segment comprising a multilayer portion, a support member, a tilt mechanism, and a spacer.

19. The optical element according to claim 18, wherein the tilt mechanism of each segment can be controlled individually.

20. The optical element according to any of claims 11 to 13, wherein the reflective element is an normal incidence EUV collector mirror with its optical surface insulated from the grounded elements including coolant supply, gas supply or positioning system.

21. The optical element according to claim 11, wherein the reflective element is configured to reflect infrared radiation.

22. The optical element according to claim 21, wherein the reflective element is configured to focus a laser onto a target in an EUV radiation source.

23. The optical element according to any of claims 1 to 10, wherein the optical element comprises a membrane arrangement configured to allow the transmission of EUV radiation therethrough.

24. The optical element according to claim 23, wherein the membrane arrangement is configured to at least partially filter out infrared and DUV radiation.

25. The optical element according to claims 23 or 24, wherein the membrane arrangement is configured to cover an opening between a projection region of the EUV lithographic apparatus comprising one or more reflective elements and a substrate region of the EUV lithographic apparatus comprising a substrate support.

26. The optical element according to any of claims 23 to 25, wherein the membrane arrangement comprises a core layer and at least one metal layer or electrically conductive layer formed on a surface of the core layer.

27. The optical element according to claim 26, wherein the spacer comprises one or more clamping members extending from a bracket and configured to contact the metal layer to clamp the membrane arrangement to the bracket.

28. The optical element according to claim 26, wherein the spacer is a bracket on which the membrane arrangement is mounted and from which one or more clamping members extend.

29. The optical element according to claim 26, wherein the spacer comprises one or more insulative pads formed on the metal layer and configured such that one or more clamping members can clamp the membrane arrangement to a bracket without coming into contact with the metal layer.

30. The optical element according to claim 11, wherein the reflective element is alignment mark.

31. An EUV lithographic apparatus comprising:

the optical element according to any of claims 1 to 30;
the grounded frame; and
a radiation source configured to generate the pulse of radiation

32. The EUV lithographic apparatus of claim 31, wherein the EUV lithographic apparatus is configured such that positive charge accumulates on the optical surface whilst the optical surface is exposed to the pulse of EUV radiation.

33. The EUV lithographic apparatus of claim 32, wherein the EUV lithographic apparatus is configured such that the accumulation of positive charge on the optical surface is such that the potential of the optical surface relative to the grounded frame becomes greater than 1 V, preferably greater than 5 V and further preferably greater than 10 V whilst the optical surface is exposed to the pulse of EUV radiation.

34. The EUV lithographic apparatus of claim 33, wherein the EUV lithographic apparatus is configured such that the potential of the optical surface relative to the grounded frame remains greater than 1 V, preferably greater than 5 V and further preferably greater than 10 V for at least 1 $\mu$s after the pulse of EUV radiation is terminated.

35. The EUV lithographic apparatus of any of claims 33 to 34, further comprising a power supply which can be connected to the optical surface to apply a bias voltage to the optical surface.

36. The EUV lithographic apparatus of claims 35, wherein the lithographic apparatus is configured such that:

the optical surface is connected to the power supply whilst a pulse of EUV radiation is not being generated by the EUV lithographic apparatus; and
the optical surface is disconnected from the power supply to be electrically isolated whilst a pulse of EUV radiation is being generated by the lithographic apparatus.

37. A method of manufacturing a device including use of the optical element according to any of claims 1 to 31.

38. A method of exposing an optical element in an EUV lithographic apparatus, the method comprising:

providing the optical element on a grounded frame of the EUV lithographic apparatus, wherein an optical surface of the optical element is configured to receive EUV radiation, and the optical surface is electrically isolated by an electrically insulating spacer;

generating a pulse of radiation with a radiation source;

exposing the optical surface with the pulse of radiation; and

accumulating positive charge on the optical surface whilst the optical surface is exposed to the pulse of radiation.

39. The method of claim 38, wherein the accumulation of positive charge on the optical surface is such that the potential of the optical surface relative to the grounded frame becomes greater than 1 V, preferably greater than 5 V and further preferably greater than 10 V whilst the optical surface is exposed to the pulse of radiation.

40. The method of claim 39, wherein the potential of the optical surface relative to the grounded frame remains than 1 V, preferably greater than 5 V and further preferably greater than 10 V for at least 1 $\mu$s after the pulse of radiation is terminated.

41. The method of any of claims 38 to 40, further comprising applying a positive bias voltage to the optical surface during periods in which a pulse of radiation is not being generated by the EUV source.

42. The method of any of claims 38 to 41, wherein the optical element is a field facet mirror, a pupil facet mirror, a collector mirror, an IR mirror or a membrane arrangement.

43. A method of manufacturing a device comprising the method of any of claims 38 to 42.

44. An optical element for an EUV lithographic apparatus, the optical element comprising:

an optical surface configured to receive EUV radiation;

a support member of the optical surface; and

a spacer that is an electrical insulator and is configured to electrically isolate the optical surface from the support member.

45. An optical element configured to be mounted on a frame of an EUV lithographic apparatus, the optical element comprising:

an optical surface configured to receive radiation;

a support member of the optical surface; and

a spacer that is an electrical insulator and is configured to electrically isolate the support member from the frame.

46. A membrane arrangement for an EUV lithographic apparatus, the membrane arrangement comprising:

an optical surface configured to receive radiation;

one or more spacers formed on the optical surface in one or more clamping regions, wherein the one or more spacers are electrical insulators and configured to electrically isolate the optical surface from one or more clamping members.

47. A membrane system configured to be mounted on a frame of an EUV lithographic apparatus, the membrane system comprising:

a membrane arrangement having an optical surface configured to receive radiation;

one or more clamping members configured to clamp the membrane; and

one or more spacers interposed between the one or more clamping members and the frame, wherein the one or more spacers are electrical insulators and configured to electrically isolate the optical surface from the frame.

48. A membrane arrangement for an EUV lithographic apparatus, the membrane arrangement comprising:

a core layer having one or more clamping regions on a surface thereof; and

a conductive layer covering a portion of the surface of the core layer,

wherein the conductive layer does not cover the one or more clamping regions.

49. A membrane arrangement for an EUV lithographic apparatus, the membrane arrangement comprising:

a core layer having first and second regions on a surface thereof;

wherein:

a conductive layer is provided on the first region; and
the second region is configured to receive a clamp surface.

A lithographic apparatus in accordance with embodiments of the present invention may be used for the manufacture of ICs.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Where the context allows, embodiments of the invention may be implemented in hardware, firmware, software, or any combination thereof. Embodiments of the invention may also be implemented by instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools.

Although specific reference may have been made above to the use of embodiments of the invention in the context of optical lithography, it will be appreciated that the invention, where the context allows, is not limited to optical lithography.

**Claims**

1. An optical element for an EUV lithographic apparatus, the optical element comprising:

   an optical surface configured to receive radiation;
   a support member that is electrically conductive; and
   a spacer that is electrically insulating and configured to electrically isolate the optical surface,
   wherein a capacitance between surfaces separated by the spacer is less than 1 $\mu$F.

2. The optical element according to claim 1, wherein the capacitance between the surfaces separated by the spacer is less than 0.1 $\mu$F, preferably less than 0.05 $\mu$F, and preferably less than 0.01 $\mu$F.

3. The optical element according to claims 1 or 2, wherein the optical element is configured to be mounted on a grounded frame.

4. The optical element according to any of the preceding claims, wherein the optical surface is configured to be electrically connected to a grounded frame via an auxiliary resistance or inductance.

5. The optical element according to claims 3 or 4, wherein the optical element is configured such that, when the optical element is mounted on the grounded frame, a resistance between the optical surface and the grounded frame is greater than 1 $\Omega$, preferably greater than 5 $\Omega$, further preferably greater than 10 $\Omega$ and further preferably greater than 100 $\Omega$.

6. The optical element according to any of claims 3 to 5, wherein the optical element is configured such that, when the optical element is mounted on the grounded frame, an inductance between the optical surface and the grounded frame is greater than 10 nH, preferably greater than 50 nH, further preferably greater than 100 nH, and further preferably greater than 1000 nH.

7. The optical element according to any of claims 3 to 6, wherein the optical element is configured such that, during a pulse of EUV radiation, the optical surface becomes positively charged due to the photo-electric effect, and a potential of the optical surface becomes greater than 1 V, preferably greater than 5 V and further preferably greater than 10 V, relative to the grounded frame.

8. The optical element according to any of the preceding claims, wherein the spacer is formed from a dielectric material.

9. The optical element according to claim 8, wherein the spacer has a dielectric breakdown strength of greater than 50 V, preferably greater than 90 V, and further preferably greater than 100 V.

10. The optical element according to claim any of the preceding claims, wherein a thickness of the spacer is greater than 1 $\mu$m, preferably greater than 10 $\mu$m and preferably greater than 100 $\mu$m.

11. The optical element according to any of the preceding claims, wherein the optical element is a reflective element.

12. The optical element according to claim 11 wherein the reflective element is configured to reflect EUV radiation.

13. The optical element according to claims 11 or 12, wherein the reflective element comprises a multilayer portion which forms the optical surface.

14. The optical element according to any of claims 11 to 13, wherein the spacer is interposed between the optical surface and the support member.

15. The optical element according to claim any of claim 11 to 13, wherein the support member is coupled to a tilt mechanism configured to be electrically connected to the grounded frame, and the spacer is interposed between the support member and the tilt mechanism.

16. The optical element according to any of claims 11 to 13, wherein the support member is coupled to a tilt mechanism, and the optical element is configured such that, when the optical element is connected to the grounded frame, the spacer is interposed between the tilt mechanism and the grounded frame.

17. The optical element according to any of claims 11 to 16, wherein the reflective element is a field facet mirror or a pupil facet mirror.

18. The optical element according to any of claims 11 to 17, wherein the optical element is formed of a plurality of segments, each segment comprising a multilayer portion, a support member, a tilt mechanism, and a spacer.

19. The optical element according to claim 18, wherein the tilt mechanism of each segment can be controlled individually.

20. The optical element according to any of claims 11 to 13, wherein the reflective element is a normal incidence EUV collector mirror with its optical surface insulated from the grounded elements including coolant supply, gas supply or positioning system.

21. The optical element according to claim 11, wherein the reflective element is configured to reflect infrared radiation.

22. The optical element according to claim 21, wherein the reflective element is configured to focus a laser onto a target in an EUV radiation source.

23. The optical element according to any of claims 1 to 10, wherein the optical element comprises a membrane arrangement configured to allow the transmission of EUV radiation therethrough.

24. The optical element according to claim 23, wherein the membrane arrangement is configured to at least partially filter out infrared and DUV radiation.

25. The optical element according to claims 23 or 24, wherein the membrane arrangement is configured to cover an opening between a projection region of the EUV lithographic apparatus comprising one or more reflective elements and a substrate region of the EUV lithographic apparatus comprising a substrate support.

26. The optical element according to any of claims 23 to 25, wherein the membrane arrangement comprises a core layer and at least one metal layer or electrically conductive layer formed on a surface of the core layer.

27. The optical element according to claim 26, wherein the spacer comprises one or more clamping members extending from a bracket and configured to contact the metal layer to clamp the membrane arrangement to the bracket.

28. The optical element according to claim 26, wherein the spacer is a bracket on which the membrane arrangement is mounted and from which one or more clamping members extend.

29. The optical element according to claim 26, wherein the spacer comprises one or more insulative pads formed on the metal layer and configured such that one or more clamping members can clamp the membrane arrangement to a bracket without coming into contact with the metal layer.

30. The optical element according to claim 11, wherein the reflective element is alignment mark.

31. An EUV lithographic apparatus comprising:

   the optical element according to any of claims 1 to 30;
   the grounded frame; and
   a radiation source configured to generate the pulse of radiation.

32. The EUV lithographic apparatus of claim 31, wherein the EUV lithographic apparatus is configured such that positive charge accumulates on the optical surface whilst the optical surface is exposed to the pulse of EUV radiation.

33. The EUV lithographic apparatus of claim 32, wherein the EUV lithographic apparatus is configured such that the accumulation of positive charge on the optical surface is such that the potential of the optical surface relative to the grounded frame becomes greater than 1 V, preferably greater than 5 V and further preferably greater than 10 V whilst the optical surface is exposed to the pulse of EUV radiation.

34. The EUV lithographic apparatus of claim 33, wherein the EUV lithographic apparatus is configured such that the potential of the optical surface relative to the grounded frame remains greater than 1 V, preferably greater than 5 V and further preferably greater than 10 V for at least 1 $\mu$s after the pulse of EUV radiation is terminated.

35. The EUV lithographic apparatus of any of claims 33 to 34, further comprising a power supply which can be connected to the optical surface to apply a bias voltage to the optical surface.

36. The EUV lithographic apparatus of claims 35, wherein the lithographic apparatus is configured such that:

   the optical surface is connected to the power supply whilst a pulse of EUV radiation is not being generated by the EUV lithographic apparatus; and
   the optical surface is disconnected from the power supply to be electrically isolated whilst a pulse of EUV radiation is being generated by the lithographic apparatus.

37. A method of manufacturing a device including use of the optical element according to any of claims 1 to 31.

38. A method of exposing an optical element in an EUV lithographic apparatus, the method comprising:

   providing the optical element on a grounded frame of the EUV lithographic apparatus, wherein an optical surface of the optical element is configured to receive EUV radiation, and the optical surface is electrically isolated by an electrically insulating spacer;
   generating a pulse of radiation with a radiation source;
   exposing the optical surface with the pulse of radiation; and
   accumulating positive charge on the optical surface whilst the optical surface is exposed to the pulse of radiation.

39. The method of claim 38, wherein the accumulation of positive charge on the optical surface is such that the potential of the optical surface relative to the grounded frame becomes greater than 1 V, preferably greater than 5 V and further preferably greater than 10 V whilst the optical surface is exposed to the pulse of radiation.

40. The method of claim 39, wherein the potential of the optical surface relative to the grounded frame remains than 1 V, preferably greater than 5 V and further preferably greater than 10 V for at least 1 μs after the pulse of radiation is terminated.

41. The method of any of claims 38 to 40, further comprising applying a positive bias voltage to the optical surface during periods in which a pulse of radiation is not being generated by the EUV source.

42. The method of any of claims 38 to 41, wherein the optical element is a field facet mirror, a pupil facet mirror, a collector mirror, an IR mirror or a membrane arrangement.

43. A method of manufacturing a device comprising the method of any of claims 38 to 42.

44. An optical element for an EUV lithographic apparatus, the optical element comprising:

an optical surface configured to receive EUV radiation;
a support member of the optical surface; and
a spacer that is an electrical insulator and is configured to electrically isolate the optical surface from the support member.

45. An optical element configured to be mounted on a frame of an EUV lithographic apparatus, the optical element comprising:

an optical surface configured to receive radiation;
a support member of the optical surface; and
a spacer that is an electrical insulator and is configured to electrically isolate the support member from the frame.

46. A membrane arrangement for an EUV lithographic apparatus, the membrane arrangement comprising:

an optical surface configured to receive radiation;
one or more spacers formed on the optical surface in one or more clamping regions, wherein the one or more spacers are electrical insulators and configured to electrically isolate the optical surface from one or more clamping members.

47. A membrane system configured to be mounted on a frame of an EUV lithographic apparatus, the membrane system comprising:

a membrane arrangement having an optical surface configured to receive radiation;
one or more clamping members configured to clamp the membrane; and
one or more spacers interposed between the one or more clamping members and the frame, wherein the one or more spacers are electrical insulators and configured to electrically isolate the optical surface from the frame.

48. A membrane arrangement for an EUV lithographic apparatus, the membrane arrangement comprising:

a core layer having one or more clamping regions on a surface thereof; and
a conductive layer covering a portion of the surface of the core layer,
wherein the conductive layer does not cover the one or more clamping regions.

49. A membrane arrangement for an EUV lithographic apparatus, the membrane arrangement comprising:

a core layer having first and second regions on a surface thereof;
wherein:

a conductive layer is provided on the first region; and
the second region is configured to receive a clamp surface.

# Fig. 1

# Fig. 2

# Fig. 3

153

152

151

150

# Fig. 4A

153

152

155

h

151

150

# Fig. 4B

153

155

h

152

151

150

## Fig. 5

## Fig. 6

# Fig. 7A

# Fig. 7B

# Fig. 7C

# Fig. 8

# Fig. 9

# Fig. 10A

411

412

410

414 413

# Fig. 10B

405

411

412

410

414 413

# Fig. 10C

401

402

404

405

# Fig. 10D

401

403

402

Fig. 11

Sn

CO

551

513

500

510

552

511

Fig. 12

Sn

CO

551

513

512

500

510

552

511

**Europäisches Patentamt**
**European Patent Office**
**Office européen des brevets**

# EUROPEAN SEARCH REPORT

Application Number

EP 23 19 8239

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2019/243258 A1 (AMENT IRENE [DE] ET AL) 8 August 2019 (2019-08-08) * paragraph [0011] * * paragraphs [0025] – [0026]; figures 1A,1B * * paragraph [0032]; figure 4 * ----- | 1-15 | INV. G03F7/00 G02B7/18 |
| A | US 2022/283428 A1 (HASPESLAGH LUC ROGER SIMONNE [BE] ET AL) 8 September 2022 (2022-09-08) * paragraph [0012] * * paragraphs [0017] – [0019] * * paragraphs [0071] – [0078]; claim 38; figures 2,3 * ----- | 1-15 | |

| | | | TECHNICAL FIELDS SEARCHED (IPC) |
|---|---|---|---|
| | | | G03F G02B |

The present search report has been drawn up for all claims

| Place of search | Date of completion of the search | Examiner |
|---|---|---|
| Munich | 5 May 2024 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 19 8239

This annex lists the patent family members relating to the patent documents cited in  the above-mentioned European search report.
The members are as contained in the European Patent Office EDP file on
The European Patent Office is in no way liable for these particulars which are merely given for the purpose of information.

05-05-2024

| Patent document cited in search report | Publication date | Patent family member(s) | Publication date |
|---|---|---|---|
| US 2019243258 A1 | 08-08-2019 | DE 102016208850 A1 | 07-12-2017 |
| | | KR 20190009754 A | 29-01-2019 |
| | | US 2019243258 A1 | 08-08-2019 |
| | | WO 2017202545 A1 | 30-11-2017 |
| US 2022283428 A1 | 08-09-2022 | CN 114402261 A | 26-04-2022 |
| | | EP 4018264 A1 | 29-06-2022 |
| | | IL 290108 A | 01-03-2022 |
| | | JP 2023506671 A | 20-02-2023 |
| | | KR 20220045158 A | 12-04-2022 |
| | | NL 2026216 A | 24-02-2021 |
| | | TW 202129355 A | 01-08-2021 |
| | | US 2022283428 A1 | 08-09-2022 |
| | | WO 2021032483 A1 | 25-02-2021 |

EPO FORM P0459

For more details about this annex : see Official Journal of the European Patent Office, No. 12/82